# EUROPEAN PATENT SPECIFICATION

(11) **EP 2 420 591 B1**
(45) Date of publication and mention of the grant of the patent: **30.10.2013**
(21) Application number: 11177929.4
(22) Date of filing: 18.08.2011
(51) Int. Cl.: C23C 16/24, C23C 16/44, C23C 16/452, C23C 16/453, C23C 16/48, C23C 16/455, C23C 16/27

(54) **Apparatus for hot wire chemical vapour deposition**
Vorrichtung zur chemischen Heißdraht-Dampfablagerung
Appareil pour le dépôt de vapeur chimique au fil chaud

(30) Priority: 20.08.2010 EP 10008724
(43) Date of publication of application: 22.02.2012
(73) Proprietor: Echerkon Technologies Ltd., Crawley West Sussex RH11 8AD (GB)
(72) Inventor: Tarazona Labrador, Antulio, Dr., Crawley West Sussex RH11 0DN (GB); Smith, Richard John, Wickham, Fareham P017 7HY (GB)
(74) Representative: Twelmeier Mommer & Partner

(56) References cited:
- JP-A- 2002 356 777
- JP-A- 2004 055 651
- JP-A- 2008 010 688
- US-A- 4 970 986
- US-A- 5 997 650
- US-A1- 2006 032 444

## Description

The invention refers to an apparatus for hot wire chemical vapour deposition of semiconductor or dielectric layers. An apparatus with the features listed in the preamble of claim 1 is known from US 5 997 650 A, US 4 970 986 A and JP 2002 356777 A.

In the so called hot wire chemical vapour deposition (HWCVD), also known as CAT-CVD or Hot Filament CVD, heated catalytic filaments made of catalysts like tungsten, tantalum or molybdenum are used to catalytically convert precursor molecules into radicals which form semiconductor or dielectric layers.

At least one filament, usually a filament array, is placed in a chamber which is then evacuated below atmospheric pressure. By installing several filaments in an array, deposition rates can be favourably increased. The filaments are then heated up to temperatures above 1400°C by passing an electric current through them. Gas precursors or vapours are then introduced in the chamber and broken down by the hot catalytic filament, to produce radicals required for deposition.

The object of the present invention is to improve quality and uniformity of deposited layers and at the same time reducing maintenance costs by optimising both the filament array, elimination of mechanical shutters between the filament and substrates, the distribution of precursor gas, simplification of the substrate temperature control and a method to minimise the effects of parasitic deposition from the chamber walls and furniture.

This object is solved by an apparatus having the features of claim 1.

The filament array is preferably held in a plane parallel to the substrates. This is usually a horizontal arrangement where the substrates are positioned above and/or below the filaments. Alternatively a vertical arrangement may be used with the substrates on one or both sides of the filament array.

The filaments are connected to the terminals of a voltage source to cause electrical heating to above 1400 °C. This results in significant thermal expansion of the filaments. According to an aspect of the present invention the filaments are preferably held under constant tension to prevent sagging and vibration, as well as providing a uniform temperature distribution on the substrate (s). This can be achieved in that the filament is held between two holders which are movable relative to each other for compensating thermal expansion of the filament. In the simplest case, one of the holders may have a weight attached to the bottom of a vertically hanging filament. This weight will maintain a constant tension of the filament. Preferably, the holders are part of an adjustable tensioner arrangement that allows adjustment of the distance of the holders whilst the filaments are hot and without breaking vacuum in the chamber. For tensioning of the filament and moving the holders relative to each other, the tensioner arrangement may comprise a spring and/or a motor, for example.

The precursor gases are injected such that they come in contact with the hot filament array before reaching the substrates. A preferred embodiment injects the gases in the same plane as the filament array. The gases are distributed evenly over the length of the filaments to ensure uniformity of deposited layers.

It is common that several layers with different characteristics need to be deposited on the same substrate; the relative concentration and total quantities of the gases have to be changed during processing. The most common approach to ensure the desired gas composition of deposited layers is to use a mechanical shutter that prevents deposition during the transition between gas composition changes. Unfortunately, a mechanical shutter can free particulates and contaminants lowering the quality of the film being deposited. It also introduces a source of frequent maintenance making it disadvantageous for large volume production applications. Accordingly in the present invention the inlet of the process chamber is connected to a bypass valve to divert process gas flow away from the process chamber to enable rapid changes of gas composition.

Further aspects and advantages of the present invention are explained in the following with respect to the enclosed figure illustrating a preferred embodiment of the invention. Corresponding parts of different embodiments are marked with identical reference numerals.
- Figure 1: shows schematically a bypass arrangement for injecting gas in to a process chamber
- Figure 2: shows schematically an arrangement of the filament array and the gas injects.
- Figure 3: shows schematically a preferred embodiment of a gas inject.
- Figure 4: shows an electron microscopy of the gas injectors porous media

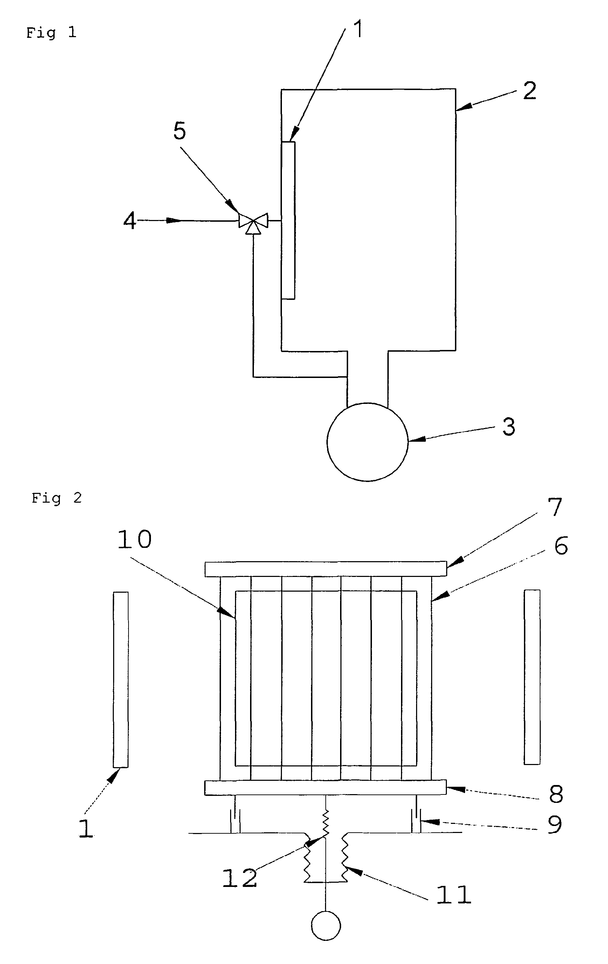

The schematic arrangement shown in figure 1 comprises a gas inject 1 inside a process chamber 2, which is connected to a vacuum pump 3. The process gas supply 4 flows through a three-way valve 5.

Typically the process gases are controlled using Mass Flow Controllers (MFCs). It is well known that when an MFC is turned on it will often overshoot the set point before stabilising the flow rate. This can take a few seconds, during which the composition of the gas mixture flowing in to the process chamber may be significantly different to the recipe. The filaments in the HWCVD reactor are always on, so deposition will start with any gas mixture present in the process chamber. This can lead to poor quality deposited layers.

A three-way valve 5 is therefore used to bypass the chamber whilst the gas flows are setup and stabilised. The gases flow directly to the vacuum pump 3. Once the flows are stabilised the three-way valve can be moved to quickly divert the gases to the process chamber so deposition can begin. At the end of the process the valve position is reverted to stop the deposition in a very short time. This sequence can be repeated to adjust the composition of the gases according to the layers required to be deposited.

By positioning the three-way valve 5 close to the gas inject 1, the volume of residual gas in the pipework and process chamber can be minimised. The bypass arrangement enables discreet changes in process chemistry and deposited layers.

Preferably the three-way valve should not have a shut-off position to prevent dead-heading the MFC gas supply. Instead of using a three-way valve, a similar bypass arrangement could be made using multiple two-way valves connected to a manifold.

The arrangement shown schematically by figure 2 comprises a filament array 6 for catalytic conversion of precursor molecules like silane. One end of the filament array is connected to an electrode 7, preferably fixed, which is in turn connected to an electrical supply. The opposite end of the array is connected to another electrode 8 which is free to move along the axis of the filaments. By applying a tensile force to this free electrode, all of the filaments in the array can be held in tension. The free end is electrically attached to the opposite terminal of the electrical supply. One or more guide rods 9 are used to ensure the filaments remain parallel to the substrate 10.

A preferred embodiment of the invention mounts the filaments in a vertical configuration as this enables gravity to be utilised to apply a tensile force to the filaments. The simplest arrangement to maintain tension is to directly apply a weight to the free end of the filaments.

However, an adjustable tensioner arrangement allows easy tuning of the array whilst the filaments are hot and without breaking vacuum in the chamber. The tensile force can be set to ensure the filaments are aligned, whilst minimising any excess load in the filaments and maximising filament life. An alternative arrangement therefore attaches the free end of the filaments to a push-pull bellows unit 11, via a spring 12.

The bellows eliminate the need for a dynamic seal for the vacuum, whilst allowing adjustment of tension from outside the chamber. Standard manually operated push-pull units are available with a linear position lock. Alternatively an automated mechanism, typically using a stepper motor, could be used to vary the linear position.

The spring 12 is used to maintain tension in the filaments whilst helping to dampen vibration.

The filaments' diameter is chosen in such a way that is part of the substrate temperature control system to avoid the use of active cooling. For example, if filaments with a diameter of about 0.1 mm operating at around 2000°C are employed for the deposition of silicon layers, then a process window of temperature between 380°C and 650°C is available without active cooling and additional heaters need to be added. For temperatures below 380°C, filaments with a diameter of 0.05 mm or smaller should be used. Furthermore, filaments with a diameter above 0.15 mm should be used for temperatures above 650°C.

In order to deposit silicon layers onto a substrate, gas precursors or vapours containing precursors molecules are then introduced in the chamber and broken down by the hot catalytic filament 6 which thereby converts precursors molecules catalytically into radicals.

In a preferred embodiment of the invention the gas injects 1 are mounted in the same plane as the filament array. The injects are at least as wide as the substrate to ensure evenly distributed gas flow, and therefore even film growth, over the entire deposition area.

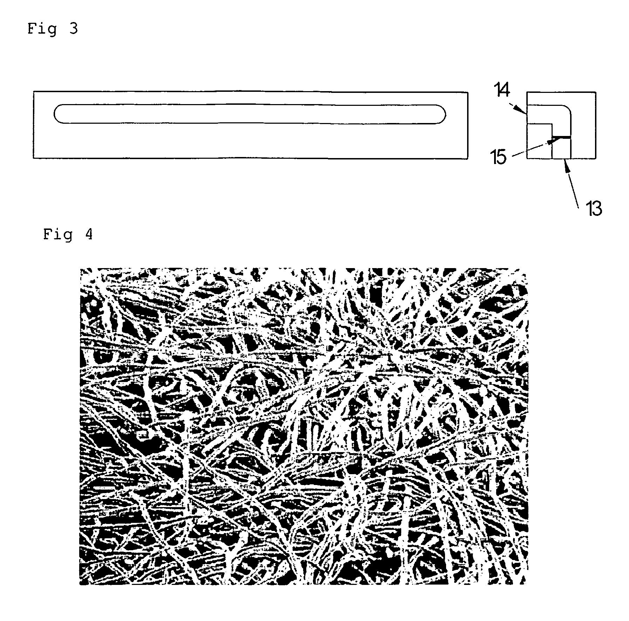

Figure 3 shows a front and a cross-section view of the gas injects. The gas precursors are introduced at an inlet 13, and come out of an outlet 14 as a uniformly distributed flow. This is achieved by using a porous media 15. Preferred material for the porous media is sintered stainless steel fibre flat sheet, with a thickness between 0.25 and 1.5 mm. The preferred porosity should be between 50 to 90% depending on the pressure range and gas viscosity. The air permeability at 2 Bar should be in the range between 10 and 1800 I/min/dm2. Obviously other materials can be used, other metals, polymers or ceramics.

In a preferred embodiment the porous media 15 is positioned at an angle to the outlet 14, such that there is no line of sight between the outlet and the porous media. This prevents deposition from occurring on the surface of the porous media, which would otherwise lead to blockages.

It has been demonstrated that HWCVD can be used as method to remove parasitic deposition on the walls and furniture of the deposition chamber. However, the removal rate, at most a few nm/min, is too small to allow a commercial implementation, where a few µm/min are required. The present apparatus overcomes this problem by producing a H2 or H2/Ar plasma in the pressure range between 0.5 and 30 mbar using the filaments as excitation source.

## Claims

1. An apparatus for performing hot wire chemical vapour deposition of semiconductor or dielectric layers, comprising
a process chamber (2) having an inlet (1) and an outlet,
a electrically heatable filament (6) for catalytic conversion of precursor gas molecules, and
holders (7, 8) between which the filament is held,
wherein the inlet (1) is connected to a bypass valve (5) to divert process gas flow away from the process chamber (2) to enable rapid changes of gas composition,
**characterized in that** the inlet (1) is covered by a gas distributor made of porous material to evenly distribute gas flow along a length.

2. An apparatus according to claim1, **characterized in that** the filament is held between holders (7, 8) which are movable relative to each other for compensating thermal expansion of the filament.

3. An apparatus according to any one of the preceding claims, **characterized in that** at least one of the holders (8) comprises a spring (12) for tensioning of the filament.

4. An apparatus according to any one of the preceding claims, **characterized in that** at least one of the holders (8) comprises a mechanism for adjusting the filament tension from the outside of the vacuum chamber.

5. An apparatus according to any one of the preceding claims, **characterized in that** the mechanism comprises a bellows unit (11) for moving the holder (8) from the outside of the vacuum chamber.

6. An apparatus according to claim 5, **characterized in that** the bellows unit is a linear bellows unit.

7. An apparatus according to any one of the preceding claims, **characterized in that** the movable holder (8) is connected to a linear guide, preferably a guide rod.

8. An apparatus according to any one of the preceding claims, **characterized in that** the filament is arranged vertically.

9. An apparatus according to any one of the preceding claims, **characterized in that** the filament is part of a filament array.

10. An apparatus according to any one of the preceding claims, **characterized in that** the porous material is sintered porous metal, preferably sintered metal meshes, or porous ceramics.

11. An apparatus according to any one of the preceding claims, **characterized in that** the gas distributor is in the same plane as the filament array.

12. An apparatus according to any one of the preceding claims, **characterized in that** there is no line-of-sight between the filament array and the gas distributor membrane.

## Patentansprüche

1. Vorrichtung zur chemischen Heißdraht-Dampfablagerung von Halbleiterschichten oder dielektrischen Schichten, mit
einer Prozesskammer (2), die einen Einlass (1) und einen Auslass aufweist,
einem elektrisch heizbaren Filament (6) zur katalytischen Umsetzung von Präkursor-Gasmolekülen, und
Haltern (7,8), zwischen denen das Filament gehalten ist,
wobei der Einlass (1) an ein Bypassventil (5) zum Umlenken von Prozessgasfluss weg von der Prozesskammer (2) angeschlossen ist, um schnelle Änderungen der Gaszusammensetzung zu ermöglichen,
**dadurch gekennzeichnet, dass** der Einlass (1) von einem Gasverteiler aus einem porösem Material bedeckt ist, um Gasstrom entlang einer Länge gleichmäßig zu verteilen.

2. Vorrichtung nach Anspruch 1, **dadurch gekennzeichnet, dass** das Filament zwischen Haltern (7,8) gehalten ist, die relativ zueinander beweglich sind, um thermische Ausdehnung des Filaments auszugleichen.

3. Vorrichtung nach einem der vorstehenden Ansprüche, **dadurch gekennzeichnet, dass** wenigstens einer der Halter (8) eine Feder (12) zum Spannen des Filaments aufweist.

4. Vorrichtung nach einem der vorstehenden Ansprüche, **dadurch gekennzeichnet, dass** wenigstens einer der Halter (8) einen Mechanismus aufweist, um die Filamentspannung von außerhalb der Vakuumkammer einzustellen.

5. Vorrichtung nach einem der vorstehenden Ansprüche, **dadurch gekennzeichnet, dass** der Mechanismus eine Balgeinheit (11) aufweist, um den Halter (8) von außerhalb der Vakuumkammer zu bewegen.

6. Vorrichtung nach Anspruch 5, **dadurch gekennzeichnet, dass** die Balgeinheit eine lineare Balgeinheit ist.

7. Vorrichtung nach einem der vorstehenden Ansprüche, **dadurch gekennzeichnet, dass** der bewegliche Halter an eine Linearführung, vorzugsweise einen Führungsstab, angeschlossen ist.

8. Vorrichtung nach einem der vorstehenden Ansprüche, **dadurch gekennzeichnet, dass** das Filament vertikal angeordnet ist.

9. Vorrichtung nach einem der vorstehenden Ansprüche, **dadurch gekennzeichnet, dass** das Filament Teil eines Filamentarrays ist.

10. Vorrichtung nach einem der vorstehenden Ansprüche **dadurch gekennzeichnet, dass** das poröse Material ein gesintertes poröses Material, vorzugsweise gesinterte Metallfasern, oder poröse Keramik ist.

11. Vorrichtung nach einem der vorstehenden Ansprüche **dadurch gekennzeichnet, dass** der Gasverteiler in derselben Ebene wie das Filamentarray ist.

12. Vorrichtung nach einem der vorstehenden Ansprüche, **dadurch gekennzeichnet, dass** zwischen dem Filamentarray und der Gasverteilermembran keine Sichtlinie ist.

## Revendications

1. Dispositif pour le dépôt en phase vapeur par procédé chimique à fil chaud de couches semi-conductrices ou diélectriques, comprenant
une chambre de traitement (2) possédant une entrée (1) et une sortie,
un filament chauffable électriquement (6) pour la conversion catalytique des molécules de gaz précurseur, et
des supports (7, 8) entre lesquels le filament est maintenu,
dans lequel l'entrée (1) est reliée à une soupape de dérivation (5) pour éloigner le flux de gaz de traitement la chambre de traitement (2) afin de permettre des changements rapides de la composition de gaz,
**caractérisé en ce que** l'entrée (1) est recouverte par un distributeur de gaz constitué d'un matériau poreux pour répartir de façon homogène le flux de gaz sur une longueur.

2. Dispositif selon la revendication 1, **caractérisé en ce que** le filament est maintenu entre des supports (7, 8) déplaçables l'un par rapport à l'autre pour compenser l'expansion thermique du filament.

3. Dispositif selon l'une quelconque des revendications précédentes, **caractérisé en ce que** l'au moins un des supports (8) comprend un ressort (12) pour mettre en tension le filament.

4. Dispositif selon l'une quelconque des revendications précédentes, **caractérisé en ce que** l'au moins un des supports (8) comprend un mécanisme pour le réglage de la tension du filament depuis l'extérieur de la chambre à vide.

5. Dispositif selon l'une quelconque des revendications précédentes, **caractérisé en ce que** le mécanisme comprend un soufflet (11) destiné à déplacer le support (8) depuis l'extérieur de la chambre à vide.

6. Dispositif selon la revendication 5, **caractérisé en ce que** le soufflet est un soufflet linéaire.

7. Dispositif selon l'une quelconque des revendications précédentes, **caractérisé en ce que** le support déplaçable (8) est relié à un guide linéaire, de préférence une tige de guidage.

8. Dispositif selon l'une quelconque des revendications précédentes, **caractérisé en ce que** le filament est agencé verticalement.

9. Dispositif selon l'une quelconque des revendications précédentes, **caractérisé en ce que** le filament fait partie d'un ensemble de filaments.

10. Dispositif selon l'une quelconque des revendications précédentes, **caractérisé en ce que** le matériau poreux consiste en un métal poreux fritté, de préférence un treillis métallique fritté, ou des céramiques poreuses.

11. Dispositif selon l'une quelconque des revendications précédentes, **caractérisé en ce que** le distributeur de gaz se trouve dans le même plan que l'ensemble de filaments.

12. Dispositif selon l'une quelconque des revendications précédentes, **caractérisé en ce qu'**il n'y a pas de visibilité entre l'ensemble de filaments et la membrane du distributeur de gaz.
